(19) **Europäisches Patentamt European Patent Office Office européen des brevets**

(11) **EP 4 451 060 B1**

(12) **FASCICULE DE BREVET EUROPEEN**

(45) Date de publication et mention de la délivrance du brevet:
**26.11.2025 Bulletin 2025/48**

(21) Numéro de dépôt: **24171234.8**

(22) Date de dépôt: **19.04.2024**

(51) Classification Internationale des Brevets (IPC):
**G03F 7/00** (2006.01)  **H01L 21/66** (2006.01)
**G01N 23/201** (2018.01)  **G01B 15/06** (2006.01)

(52) Classification Coopérative des Brevets (CPC):
**G01N 23/201; G01B 15/06; G03F 7/70633; H01L 22/12;** G01N 2223/0566; G01N 2223/6113; G01N 2223/646

(54) **PROCÉDÉ D'IDENTIFICATION D'UN DÉFAUT AFFECTANT UN MOTIF DE CONTRÔLE PORTÉ PAR UN COMPOSANT MICROÉLECTRONIQUE ; PROCÉDÉ DE CONTRÔLE, SYSTÈME INSTRUMENTAL ET PRODUIT PROGRAMME D ORDINATEUR ASSOCIÉS**

VERFAHREN ZUR IDENTIFIZIERUNG EINES FEHLERS, DER EIN VON EINER MIKROELEKTRONISCHEN KOMPONENTE GETRAGENES KONTROLLMUSTER BEEINFLUSST, STEUERVERFAHREN, ENTSPRECHENDES INSTRUMENT UND COMPUTERPROGRAMMPRODUKT

METHOD FOR IDENTIFYING A DEFECT AFFECTING A TEST PATTERN CARRIED BY A MICROELECTRONIC COMPONENT; ASSOCIATED TEST METHOD, INSTRUMENT SYSTEM AND COMPUTER PROGRAM PRODUCT

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **21.04.2023 FR 2304035**

(43) Date de publication de la demande:
**23.10.2024 Bulletin 2024/43**

(73) Titulaire: **Commissariat à l'Energie Atomique et aux Energies Alternatives 75015 Paris (FR)**

(72) Inventeurs:
• **FREYCHET, Guillaume 38054 GRENOBLE CEDEX 9 (FR)**
• **GERGAUD, Patrice 38054 GRENOBLE CEDEX 9 (FR)**

(74) Mandataire: **Lavoix 2, place d'Estienne d'Orves 75441 Paris Cedex 09 (FR)**

(56) Documents cités:
EP-A1- 4 137 889      US-A1- 2007 224 518
US-A1- 2015 117 610      US-A1- 2016 320 319

**Description**

La présente invention relève du domaine des procédés de mesure par diffusion des rayons X aux petits angles - CD-SAXS (selon l'anglais « Critical-Dimension Small Angle X-ray Scattering »), notamment des procédés de mesure par transmission - T-SAXS (pour « transmission - Small Angle X-ray Scattering ») ou par réflexion - GI-SAXS (pour « Grazing Incident - Small Angle X-ray Scattering »).

Plus particulièrement, la présente invention concerne un procédé d'identification rapide du type dont relève un défaut affectant un motif de contrôle résultant de la superposition de deux réseaux de lignes portés par un composant microélectronique.

La fabrication par empilement d'un composant microélectronique nécessite que les différents niveaux le constituant soient superposés avec une grande précision, de manière à ce que les éléments portés par ces différents niveaux soient correctement positionnés les uns par rapport aux autres afin de garantir le bon fonctionnement du composant final.

Il est connu de contrôler la précision de fabrication en utilisant un motif de contrôle résultant de la superposition d'un second réseau de lignes réalisé sur un second niveau du composant, au-dessus d'un premier réseau de lignes réalisé sur un premier niveau du composant. Le premier réseau de lignes, respectivement le second réseau de lignes, est fabriqué en même temps que la réalisation des éléments du premier niveau, respectivement du second niveau.

Ce contrôle de précision s'effectue en mesurant les défauts affectant le motif de contrôle.

Par exemple, US 2016/0320319 A1 divulgue la mesure, au moyen d'une technique d'imagerie TSAXS, GISAXS ou autre, d'un défaut affectant le motif résultant de la superposition des deux réseaux de lignes. Le défaut mesuré est la combinaison d'un défaut de recouvrement et d'un facteur de forme.

Par exemple encore, US 2015/0117610 A1 divulgue un procédé de mesure du recouvrement entre les deux réseaux de lignes en mettant en oeuvre une technique TSAXS ou GISAXS.

Par exemple encore, EP 4137 889 A1 envisage la mise en oeuvre d'une technique TSAXS pour mesurer différents paramètres, dont un défaut de recouvrement et l'angle des parois latérales du motif résultant de la superposition des réseaux de lignes.

Toujours, sur ce sujet, la demanderesse a déposé la demande de brevet FR 22 02371, dans laquelle il s'agissait de mesurer un défaut de recouvrement, ou « overlay » (en reprenant abusivement le terme anglais comme le ferait l'homme du métier). Dans ce document, l'overlay est défini comme une translation du second réseau de lignes par rapport au premier réseau de lignes. Cette translation est caractérisée par un angle $\alpha$ entre des première et seconde directions : la première direction étant la direction normale aux lignes d'un réseau, dans le plan de ce réseau ; et la seconde direction passant par les centres géométriques des sections transversales d'une ligne du premier réseau et d'une ligne du second réseau, la paire de lignes considérées devant être parfaitement superposées lorsque l'angle $\alpha$ est égal à 90°.

Cependant, la géométrie du motif de contrôle peut être altérée d'autres façons qu'une simple translation décalant un réseau de lignes par rapport à l'autre.

Ainsi, dans la demande de brevet FR 23 01672, le procédé de mesure permet d'évaluer non seulement un angle de translation, pour caractériser un défaut de translation, mais également un angle de déformation des bords des lignes des réseaux, pour caractériser un défaut de déformation.

La reconstruction tridimensionnelle de la forme des lignes à partir des mesures obtenues par CD-SAXS s'appuie sur une modélisation qui est d'autant plus complexe que l'on considère un plus grand nombre de paramètres de description des défauts potentiels. L'extraction de mesures peut donc prendre beaucoup de temps, notamment pour l'acquisition de la quantité de données nécessaires à l'analyse conformément à la modélisation utilisée.

Le but de la présente invention est ainsi de proposer un procédé de mesure autorisant une simplification de l'extraction d'informations sur la géométrie du motif de contrôle.

Pour cela l'invention a pour objet un procédé d'identification de type de défaut, un procédé de contrôle de la fabrication, un système instrumental du type T-SAXS ou GI-SAXS et un produit programme d'ordinateur selon les revendications annexées.

L'invention et ses avantages seront mieux compris à la lecture de la description détaillée qui va suivre d'un mode de réalisation particulier, donné uniquement à titre d'exemple non limitatif, cette description étant faite en se référant aux dessins annexés sur lesquels :

La figure 1 est une représentation schématique d'un système instrumental d'identification des défauts affectant la géométrie du motif de contrôle par la mise en oeuvre d'une technique T-SAXS ;

La figure 2 est une représentation de la transformée de Fourier d'un motif de contrôle pour lequel la géométrie du motif de contrôle est sans défaut ;

La figure 3 est une représentation schématique de la géométrie du motif de contrôle associant déformation des lignes des deux réseaux superposées et translation des deux réseaux superposés ;

La figure 4 est une représentation sous forme de blocs d'un mode de réalisation du procédé d'identification selon l'invention ;

La figure 5 est un graphe représentant l'intensité en fonction de la coordonnée $q_z$ pour quatre tiges de Bragg d'une figure de diffraction ; et,

La figure 6 est une représentation sous forme de blocs d'un mode de réalisation d'un procédé de mesure intégrant le procédé d'identification selon l'invention.

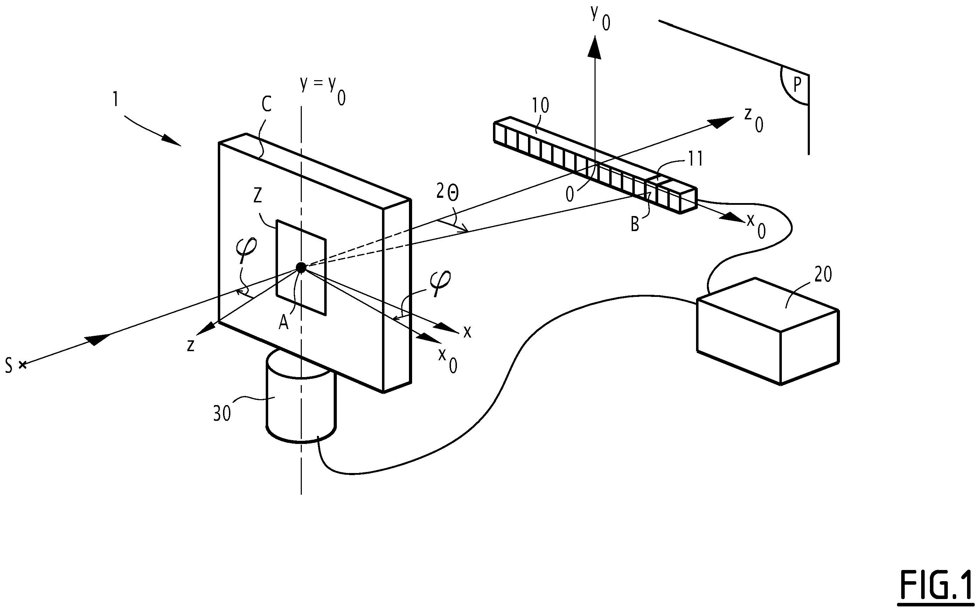

La figure 1 représente un système instrumental 1 adapté à une mesure par transmission T-SAXS.

Une source S de rayon X émet un faisceau de rayon X selon une direction $z_0$, perpendiculairement à un plan d'observation P. Le faisceau incident tombe en un point origine O du plan d'observation P. Des directions $x_0$ et $y_0$ définissent un repère orthonormal du plan P.

Un composant microélectronique C est interposé entre la source S et le plan d'observation P.

Le composant C est muni d'un motif de contrôle Z permettant d'évaluer la qualité de fabrication du composant C. Le motif de contrôle Z est constitué d'un premier niveau comportant un premier réseau de lignes et, superposé au premier niveau, un second niveau comportant un second réseau de lignes.

De préférence, la surface du motif de contrôle Z affleure le reste de la surface du composant C.

Le centre A du motif de contrôle Z est placé sur l'axe d'incidence du faisceau de rayons X.

Un repère orthonormal xyz est associé au composant C. Ce repère est attaché au centre A du motif de contrôle Z de sorte que la direction y corresponde à la direction $y_0$, et que la direction z soit normale à la surface du motif de contrôle Z.

Comme précisé ci-après, les lignes des réseaux de lignes qui permettent de mesurer l'overlay sont disposées parallèlement à l'axe $y_0$, de façon à obtenir des pics de Bragg selon l'axe $x_0$.

Le composant C est placé sur un support 30 permettant de faire tourner le composant C autour de la direction y de manière à modifier l'angle d'incidence $\varphi$ du faisceau de rayons X sur le motif de contrôle Z, c'est-à-dire l'angle entre la direction z et la direction $z_0$, qui est également l'angle entre la direction x et la direction $x_0$.

Un détecteur 10 est placé dans le plan d'observation P. Il est par exemple composé d'une barrette de capteurs disposés selon la direction $x_0$.

L'intensité au point B de l'axe $x_0$, mesurée par le capteur localisé au point B, dépend de l'angle $2\theta$ entre la direction AO et la direction AB. Cette intensité est notée $I(\theta)$.

Comme connu en soi, l'image dans le plan d'observation P est en relation avec la transformée de Fourier spatiale du motif de contrôle Z éclairé par le faisceau incident.

Dans l'espace réciproque, la coordonnée associée à la direction $x_0$ est la fréquence spatiale $q_0$ définie par :

$$q_0 = \frac{4\sin(\theta)}{\lambda} \tag{1}$$

où $\lambda$ est la longueur d'onde des rayons X utilisés.

Soit, toujours dans l'espace réciproque, mais en considérant les fréquences spatiales $q_x$ et $q_z$, respectivement associées aux directions x et z du repère lié au motif de contrôle Z :

$$q_x = q_0 \cos(\varphi) \tag{2}$$

$$q_z = q_0 \sin(\varphi) \tag{3}$$

Le détecteur 10 est connecté à un dispositif électronique, représenté de manière schématique sur la figure 1 par un cube portant la référence 20.

Le dispositif 20 comporte une électronique de contrôle permettant de commander le support 30 pour qu'il positionne le composant C selon une valeur de consigne de l'angle d'incidence $\varphi$.

Le dispositif 20 comporte également une électronique d'acquisition permettant d'effectuer des prétraitements adaptés sur les signaux délivrés par chacun des capteurs du détecteur 10 et à les numériser.

Le dispositif 10 comporte en outre un calculateur pour le traitement des signaux prétraités et numérisés. Le calculateur est un ordinateur comportant des moyens de calcul, tels qu'un processeur, et des moyens de mémorisation, tels qu'une mémoire. La mémoire stocke notamment les instructions de programmes d'ordinateur, en particulier un programme dont l'exécution permet la mise en oeuvre d'un procédé d'identification des défauts affectant le motif de contrôle.

D'un point de vue théorique, il est possible de calculer exactement la transformée de Fourier spatiale du motif de contrôle.

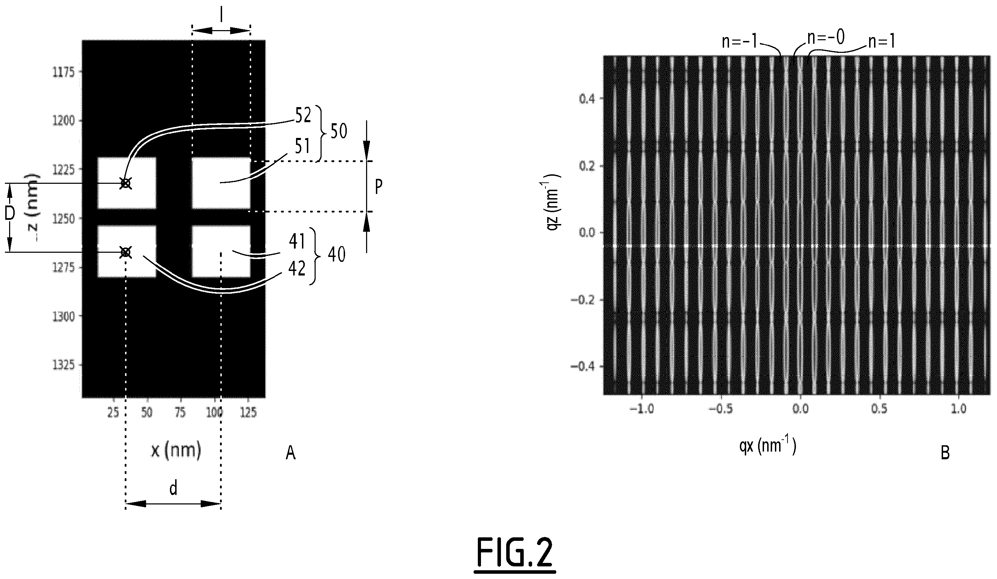

Ainsi, la partie A de la figure 2 représente, dans l'espace direct des coordonnées x et z (le plan xz étant le plan transversal aux premier et second réseaux de lignes), une fraction du motif de contrôle Z porté par le composant C. Sont ici représentées les sections transversales de deux lignes 41 et 42 du premier réseau de lignes 40 et deux lignes 51 et 52 du second réseau de lignes 50. Les lignes de chacun de ces réseaux s'étendent selon la direction y, c'est-à-dire perpendiculairement au plan de la figure 2.

Dans le cas d'un motif de contrôle Z sans défaut (représenté sur la figure 2A), c'est-à-dire lorsque le motif de contrôle Z respecte une géométrie idéale, une ligne d'un réseau présente une section transversale rectangulaire, les parois latérales (ou bords) d'une ligne étant perpendiculaires au fond de cette ligne.

Une ligne présente une largeur l et une profondeur p.

Deux lignes d'un même réseau sont espacées d'un pas d.

Le pas entre une ligne du premier réseau et la ligne correspondante du second réseau est noté D. Ce pas selon l'épaisseur du composant est considéré comme égal à p dans la suite de la présente description (les deux réseaux étant superposés directement l'un au-dessus de l'autre), car ce pas selon l'épaisseur n'a pas d'effets mesurables sur la figure de diffraction.

Toujours selon la géométrie idéale, les premier et second réseaux de lignes sont parfaitement superposés.

Le calcul exact de la transformée de Fourier spatiale de ce motif conduit à la figure de diffraction (ou cartographie de diffraction) représentée sur la partie B de la figure 2. Il s'agit d'une représentation dans l'espace réciproque des fréquences spatiales $q_x$ et $q_z$, qui sont respectivement conjuguées des coordonnées x et z.

Pour une valeur nulle de $q_z$, la transformée de Fourier présente, selon la direction $q_x$, une succession de maximums principaux, ou pic de Bragg. Chaque pic de Bragg est identifié par un entier n, dénommé ordre de Bragg.

Pour une valeur $q_x^n$ donnée, c'est-à-dire pour le pic de Bragg d'ordre n, l'intensité selon la direction $q_z$ forme ce que l'on dénomme la tige de Bragg d'ordre n. Une tige de Bragg présente une alternance de maximums et de minimums locaux.

On peut noter $q_z^{n,0}$ la position du maximum principal de la tige de Bragg d'ordre n. $q_z^{n,0}$ est égale à 0 pour un motif de contrôle de géométrie idéale.

Pour i entier positif, le $i^{ème}$ maximum secondaire de la partie supérieure de la tige de Bragg d'ordre n est situé en $q_z^{n,i}$ ( $q_z^{n,i}$ positif) et le $i^{ème}$ maximum secondaire de la partie inférieure de la tige de Bragg d'ordre n est situé en $q_z^{n,-i}$ ( $q_z^{n,-i}$ négatif).

Sur la partie B de la figure 2, la tige de Bragg d'ordre n est symétrique par rapport à l'axe $q_z$. Ainsi, la position du $i^{ème}$ maximum secondaire de la partie supérieure de la tige de Bragg d'ordre n est égale (au signe près) à la position du $i^{ème}$ maximum secondaire de la partie inférieure de la tige de Bragg d'ordre n : $q_z^{n,-i} = -q_z^{n,i}$ .

De plus, on constate que, lorsqu'il n'y a pas d'overlay, la position selon l'axe $q_z$ du $i^{ème}$ maximum secondaire d'une tige de Bragg est constante, quel que soit l'ordre de Bragg n considéré ( $q_z^{n,i} = q_z^i$ ).

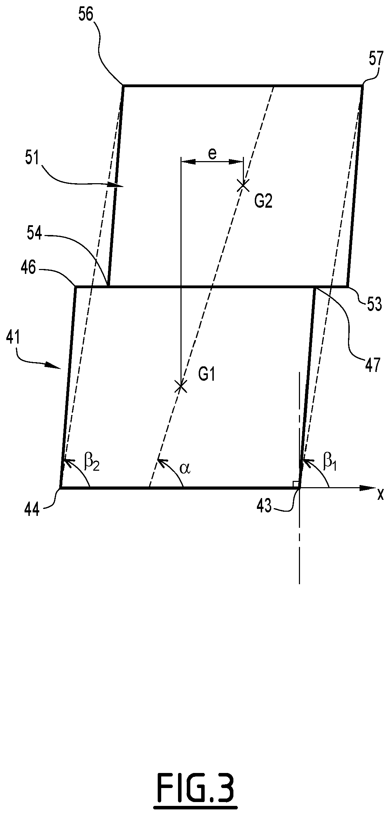

Comme illustré sur la figure 3, deux types de défaut peuvent potentiellement affecter la géométrie du motif de contrôle Z de sorte qu'il s'écarte de la géométrie idéale de la figure 2 :

- un défaut de translation : une translation d'un réseau de lignes par rapport à l'autre réseau de lignes, décrit par un angle de translation $\alpha$ ; et
- un défaut de déformation : une déformation des bords des lignes des deux réseaux, décrit par un angle de déformation $\beta_{moy}$.

Plus précisément, le motif de contrôle Z peut présenter un défaut résultant de la translation d'un réseau de lignes par rapport à l'autre selon une direction normale aux lignes d'un réseau, dans le plan de ce réseau (direction x).

Par exemple, sur la figure 3, la ligne supérieure 51 est translatée selon la direction x d'une distance e par rapport à la ligne inférieure 41.

Ce défaut de translation est décrit par l'angle $\alpha$, ou angle de translation, entre la direction normale x et la direction reliant les centres géométriques $G_1$ et $G_2$ d'une paire de lignes.

Le motif de contrôle peut également présenter un défaut résultant de la déformation des lignes des réseaux de lignes, chaque ligne ayant alors une section en losange (dit autrement, les parois latérales d'une ligne ne sont plus à angle droit par rapport au fond de cette ligne).

Par exemple, sur la figure 3, les bords entre les coins 44 et 46, d'une part, et 43 et 47, d'autre part, de la ligne inférieure 41 sont inclinés, et les bords entre les coins 54 et 56, d'une part, et 53 et 57, d'autre part, de la ligne supérieure 51 sont inclinés.

Pour quantifier cette déformation, on définit un premier angle de bord $\beta_1$ comme l'angle entre la direction x et la direction joignant le coin inférieur droit 43 de la première ligne 41 et le coin supérieur droit 57 de la seconde ligne 51.

On définit un second angle de bord $\beta_2$ comme l'angle entre la direction x et la direction joignant le coin inférieur gauche 44 de la première ligne 41 et le coin supérieur gauche 56 la seconde ligne 51.

L'angle de déformation $\beta_{moy}$ caractérisant ce défaut de déformation est alors défini comme la moyenne des tangentes des premier et second angles de bord : $\tan(\beta_{moy}) = \tan(\beta_1) + \tan(\beta_2)$.

Dans le cas où le motif de contrôle est affecté par un défaut de translation mais pas par un défaut de déformation, on montre que $\beta_{moy} = \alpha$, de sorte que ces deux paramètres permettent alors d'extraire la même information sur la géométrie du motif.

En revanche, lorsque le motif de contrôle est affecté par un défaut de translation et par un défaut de déformation, on perd l'égalité $\beta_{moy} = \alpha$, et les paramètres $\beta_{moy}$ et $\alpha$ permettent alors d'extraire des informations différentes sur l'écart à la géométrie idéale.

Le procédé selon l'invention permet d'identifier, rapidement, la nature du défaut affectant le motif de contrôle.

En analysant automatiquement les symétries existantes (axiales ou centrales) sur une figure de diffraction, avantageusement partielle, ramenée dans l'espace ($q_x$, $q_z$), il est possible de classer le profil du motif de contrôle ayant conduit à cette figure de diffraction.

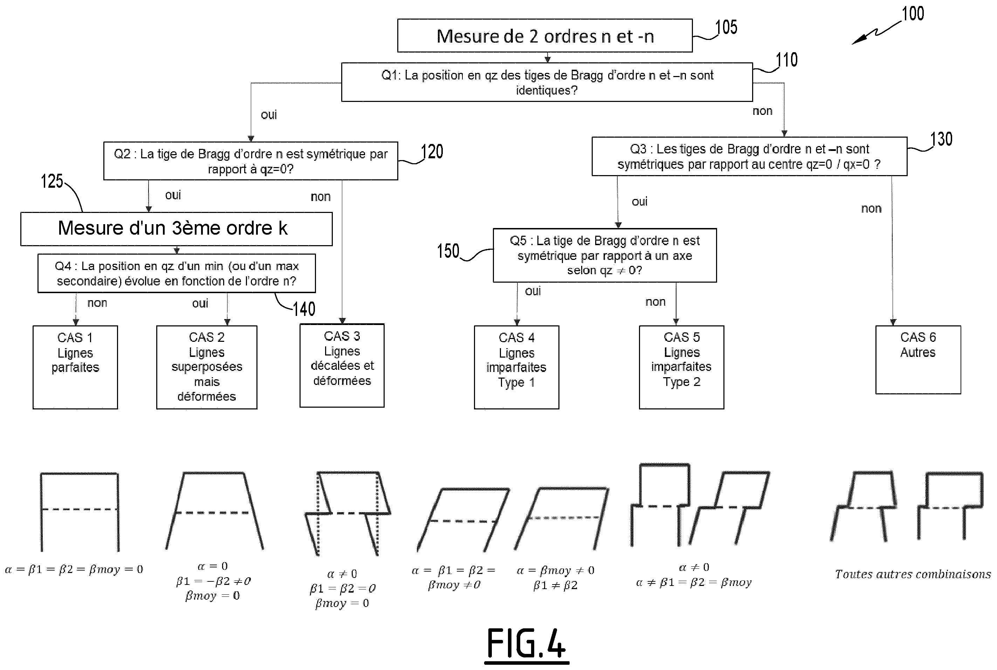

Plus précisément, dans le mode de réalisation présenté ici en détail, le procédé 100 permet de classer un défaut selon six cas ou classes possibles. Chacun de ces cas est représenté schématiquement au bas de la figure 4.

Les différents cas possibles sont :

Cas 1 : il correspond au cas idéal où le motif n'a pas défaut, les lignes étant parfaitement superposées et leurs bords n'étant pas déformés : $\alpha = \beta1 = \beta2 = \beta moy = 90°$;

Cas 2 : il correspond à un défaut de déformation avec compensation, les lignes étant superposées, mais déformées de sorte que la moyenne des déformations soit nulle : $\alpha = 90°$ ; $\beta1 = -\beta2 \neq 90°$ ; $\beta moy = 90°$ ;

Cas 3 : il correspond à un défaut de translation, les lignes étant décalées, mais leurs bords n'étant pas déformés : $\alpha \neq 90°$ ; $\beta1 = \beta2 = \beta moy = 90°$;

Cas 4 : il correspond à un défaut de translation et un défaut de déformation égaux, les lignes étant décalées et leurs bords déformés d'un même angle : $\alpha = \beta1 = \beta2 = \beta moy \neq 90°$ ou les lignes sont décalées et leurs bords déformés d'un même angle moyen : $\alpha = \beta moy \neq 90°$ mais $\beta1 \neq \beta2$ ;

Cas 5 : il correspond à un défaut de translation et un défaut de déformation quelconque, les lignes étant décalées et leurs bords déformés, mais selon des angles différents $\alpha \neq 90°$ ; $\alpha \neq \beta moy$ ; et $\beta1 = \beta2 = \beta moy$ ; et,

Cas 6 : il correspond à un défaut complexe. Cette classe regroupe toutes les autres combinaisons conduisant à des déformations plus compliquées du motif.

La figure 4 est une représentation sous forme de blocs du procédé 100.

Dans l'étape 105, le dispositif de mesure de la figure 1 est mis en oeuvre pour acquérir une figure de diffraction de la zone de contrôle d'un composant testé. La figure de diffraction comporte avantageusement uniquement deux tiges de Bragg. Ces deux tiges de Bragg doivent être symétriques l'une de l'autre par rapport à l'axe $q_z$. Il s'agit donc de la paire de tiges de Bragg d'ordre -n et d'ordre n.

Dans l'étape 110, un premier test Q1 est effectué sur la figure de diffraction acquise à l'étape 105. Ce premier test consiste à vérifier si les positions selon l'axe $q_z$ des maximums de la tige de Bragg d'ordre -n sont identiques aux positions selon l'axe $q_z$ des maximums de la tige de Bragg d'ordre n. Les maximums considérés ici comportent au moins le maximum principal $q_z^{n,o}$ et $q_z^{-n,o}$ des tiges de Bragg d'ordre n et -n et un maximum secondaire $q_z^{n,i}$ et $q_z^{-n,i}$ des tiges de Bragg d'ordre n et -n. Dans l'affirmative, le procédé passe à l'étape 120 et dans la négative le procédé passe à l'étape 130.

Dans l'étape 120, un second test Q2 est effectué sur la figure de diffraction acquise à l'étape 105. Ce second test consiste à vérifier si la tige de Bragg d'ordre n (ou la tige de Bragg d'ordre -n) est symétrique par rapport à l'axe $q_x$ (c'est-à-dire symétrique par rapport à l'axe passant par $q_z = 0$). Par exemple, la position selon l'axe $q_z$ du $i^{ème}$ maximum de la partie supérieure de la tige de Bragg d'ordre n est-elle identique à la position selon l'axe $q_z$ du $i^{ème}$ maximum de la partie inférieure de la tige de Bragg d'ordre n ? A-t-on $q_z^{n,i} = q_z^{n,-i}$ ? Dans l'affirmative, le procédé passe à l'étape 125, et dans la négative le procédé est stoppé et l'on considère que le défaut correspond au cas 3.

Dans l'étape 125, le dispositif de mesure de la figure 1 est activé pour compléter la figure de diffraction obtenue à l'étape 105 afin d'obtenir une troisième tige de Bragg, par exemple la tige d'ordre k. L'étape 125 est mise en oeuvre uniquement si, à l'étape 105, cette troisième tige n'a pas déjà été acquise.

Puis, dans l'étape 140, un quatrième test Q4 est effectué sur la figure de diffraction complétée. Ce quatrième test consiste à vérifier si la position selon l'axe $q_z$ du $i^{ème}$ extremum (minimum ou maximum) évolue en fonction de l'ordre. Par exemple, $q_z^{-n,i}$, $q_z^{n,i}$ et $q_z^{k,i}$ sont-ils en progression linéaire en fonction de l'ordre ? Dans l'affirmative, le procédé 100 s'arrête et l'on considère que le motif correspond au cas 2. Dans la négative, le procédé s'arrête et l'on considère que le défaut correspond au cas 1.

Dans l'étape 130, un troisième test Q3 est appliqué sur la figure de diffraction obtenue à l'étape 105 (qui présente au minimum les deux tiges de Bragg d'ordre -n et n). Ce troisième test consiste à vérifier si les tiges de Bragg d'ordre -n et n sont symétriques par rapport à l'origine de la figure de diffraction, c'est-à-dire par rapport au point de coordonnées $q_z = 0$ et $q_x = 0$. A-t-on : $q_z^{n,i} = q_z^{-n,-i}$ ? Dans l'affirmative, le procédé passe à l'étape 150. Dans la négative, le procédé s'arrête et le défaut correspond au cas 6.

Dans l'étape 150, un cinquième test Q5 est appliqué sur la figure de diffraction. Ce cinquième test consiste à vérifier si la tige de Bragg d'ordre n est symétrique par rapport à un point central de cette tige, mais qui a une coordonnée non nul selon l'axe $q_z$. A-t-on : $q_z^{n,i} - q_z^{n,0} = q_z^{n,-i} - q_z^{n,0}$ ? Dans l'affirmative, le procédé s'arrête et le défaut correspond au cas 4. Dans la négative, le procédé s'arrête et le défaut est considéré comme relevant du cas 5.

Il est à noter que l'adjectif numéral associé à chacun des tests du procédé 100 n'indique pas l'ordre dans lequel ce test est effectué. Par exemple, le troisième test Q3 est appliqué uniquement si la réponse au premier test Q1 est négative. Il s'agit alors du second test qui est effectivement appliqué sur la figure de diffraction analysée. Dans cette alternative, les deuxième et quatrième tests, Q2 et Q4, ne sont pas appliqués. En fonction de la réponse à ce troisième test Q3, le cinquième test Q5 sera ou non appliqué.

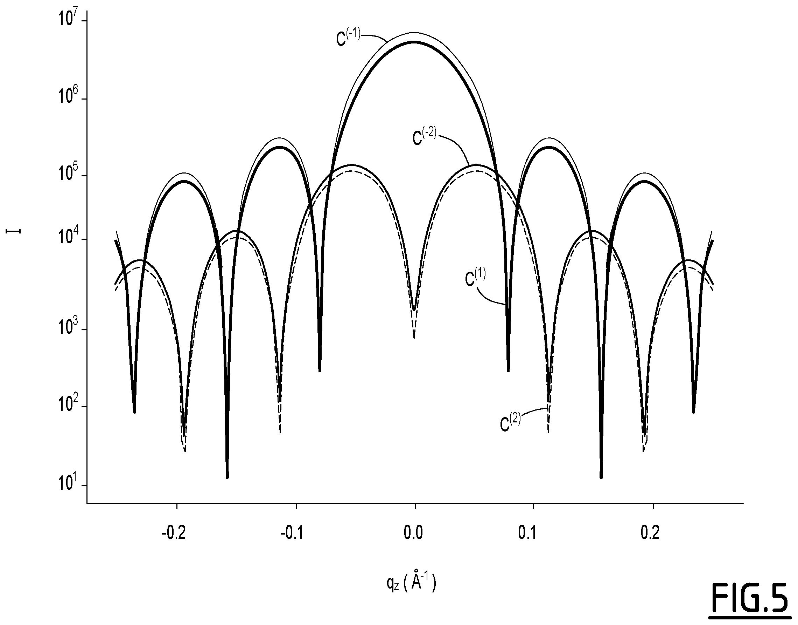

La figure 5 représente le profil d'intensité de quatre tiges de Bragg relevées sur une figure de diffraction obtenue en sortie du dispositif de la figure 1. La courbe C$^{(-2)}$ correspond à la tige de Bragg d'ordre -2, la courbe C$^{(-1)}$ correspond à la tige d'ordre -1 ; la courbe C$^{(1)}$ correspond à la tige d'ordre 1 et la courbe C$^{(2)}$ correspond à la tige d'ordre 2.

Il est à noter que, sur la figure 5, les profils ont été légèrement décalés selon la direction d'intensité pour aider à la visualisation. Les profils C$^{(-2)}$ et C$^{(2)}$ d'une part et les profils C$^{(-1)}$ et C$^{(1)}$ d'autre part se superposerait parfaitement sans ce léger décalage pour la visualisation.

L'étape 105 permet par exemple l'acquisition des courbes C$^{(2)}$ et C$^{(-2)}$.

L'application du premier test Q1 de l'étape 110 montre que les positions des maximas est identique pour une paire de tiges d'ordre opposés : $q_z^{2,i} = q_z^{-2,i}$.

L'application du second test Q2 de l'étape 120 montre qu'il y a une symétrie selon $q_z$ : $q_z^{2,i} = q_z^{2,-i}$.

L'étape 125 permet de compléter la figure de diffraction avec par exemple l'acquisition des courbes C$^{(1)}$ et C$^{(1)}$.

L'application du quatrième test Q4 de l'étape 130 montre que la position des maximas se déplace avec les ordres : $q_z^{-2,i} \neq q_z^{-1,i} \neq q_z^{+1,-i} \neq q_z^{2,i}$.

Nous nous trouvons donc avec un défaut relevant du cas 2.

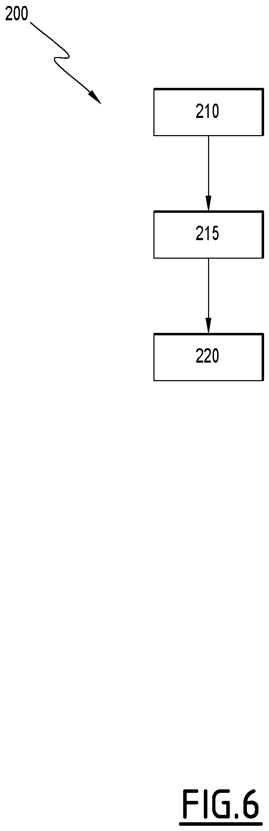

Comme illustré par le schéma de la figure 6, le procédé d'identification 100 est avantageusement intégré dans un procédé de contrôle 200.

Le procédé 200 est mise en oeuvre le long d'une chaîne de fabrication en série d'un composant microélectronique. Celui-ci est un composant multi-niveau comportant au moins un premier niveau et un second niveau.

Pour le contrôle de la précision de fabrication, est gravé sur chaque composant un motif de contrôle. Celui-ci résulte de la superposition d'un premier réseau de lignes réalisé au cours de la fabrication du composant sur le premier niveau et d'un second réseau de lignes réalisé au cours de la fabrication sur le second niveau.

Le procédé 200 est réalisé sur un premier composant.

Il consiste d'abord, dans une étape 210, à identifier le type du défaut affectant possiblement le motif de contrôle porté par le premier composant. Pour ce faire le procédé d'identification 100 est mis en oeuvre. Cela permet de déterminer le cas dont relève le défaut.

Puis, dans une étape 220, les conditions de fabrication sont ajustées en fonction du résultat de l'étape 210, c'est-à-dire le type de défaut identifié.

Cet ajustement des conditions de fabrication peut consister simplement à modifier les paramètres de fonctionnement des différents dispositifs le long de la chaîne de fabrication et de chercher à déterminer des conditions de fabrication optimales progressivement par une approche essai/erreur en itérant les étapes 210 et 220 sur une succession de composants microélectroniques sortant de la chaîne de production.

En variante, l'étape 210 d'identification du type du défaut est suivie d'une étape 215 de mesure d'une valeur d'au moins un paramètre caractéristique du défaut affectant le motif du composant microélectronique contrôlé.

Cette mesure tient compte du résultat de l'étape 210 dans le choix de la méthode instrumentale la plus adaptée pour acquérir des données de mesure en vue de l'extraction de ce paramètre caractéristique (si les données déjà acquises aux étapes 105 et 125 ne suffisent) et/ou dans la méthode d'analyse utilisant une modélisation adaptée pour extraire la valeur du paramètre caractéristique considéré à partir des données de mesure.

La méthode d'analyse précise de l'angle $\alpha$ dans le cadre de l'overlay des cas 2 et 3 ; une méthode d'extraction précise de l'angle $\beta_{moy}$ dans le cadre de l'overlay des cas 4 et 5 ; et une méthode d'extraction précise du profil tridimensionnel en profondeur des lignes pour le cas 1 par exemple.

La méthode instrumentale choisie est préférentiellement une technique CD-SAXS, mais d'autres techniques peuvent être utilisées pour réaliser l'acquisition de données de mesure.

Le choix de la méthode instrumental couvre également la définition de la partie de la figure de diffraction qu'il est nécessaire et suffisant d'acquérir pour obtenir les données de mesure permettant une caractérisation précise du défaut.

La partie de la figure de diffraction à acquérir peut, à son tour, impacter le dispositif instrumental à utiliser pour la mesure précise.

Par exemple, si l'étape 210 d'identification montre que la présence d'overlay se caractérise par une asymétrie selon l'axe $q_x$, la mesure d'une tige de Bragg unique est suffisante. Alors, un détecteur ponctuel peut suffire pour une mesure en T-SAXS. Pour détecter la présence de l'angle $\beta_{moy}$, la mesure de plusieurs ordres de Bragg est nécessaire. Alors un détecteur monodimensionnel est utilisé pour une mesure en T-SAXS.

Enfin, l'étape d'ajustement 220 prend en compte la valeur mesurée de chaque paramètre caractéristique pour adapter les conditions de fabrication et progressivement conduire à la fabrication de composant dont le motif de contrôle ne comporte aucun défaut.

L'homme du métier constatera que le présent procédé permet l'identification de la nature d'un défaut affectant le motif de contrôle pour adapter ensuite la méthode d'analyse et d'extraction des valeurs des paramètres caractérisant ce défaut.

Si, dans le mode de réalisation présenté ci-dessus, une méthode instrumentale par transmission T-SAXS a été utilisée, en variante, une méthode instrumentale par réflexion GI-SAS peut être mise en oeuvre.

Le CD-SAXS étant une méthode non-triviale de caractérisation, le procédé selon l'invention permet d'aiguiller vers la méthode d'analyse adéquate de la figure de diffraction. Il est indépendant de la modélisation. Une fois le défaut classifié, la modélisation adaptée (c'est-à-dire simplifiée par rapport à une modélisation complexe intégrant l'ensemble des paramètres caractéristiques de tous les défauts potentiels) est appliquée sur des données de mesure pour extraire une information précise.

Avec le présent procédé, la technique de contrôle par CD-SAXS devient particulièrement avantageuse le long d'une chaîne de fabrication pour, après chaque mesure de l'overlay, réaligner les équipements de fabrication au cours du processus de lithographies lui-même. Ceci permet de corriger la précision de fabrication au cours du fonctionnement de la chaine de fabrication.

## Revendications

**1.** Procédé d'identification (100) d'un type dont relève un défaut affectant un motif de contrôle (Z) porté par un composant microélectronique (C), le composant microélectronique comportant au moins un premier niveau et un second niveau, le motif de contrôle résultant de la superposition d'un premier réseau de lignes, réalisé au cours de la fabrication du composant microélectronique, sur le premier niveau et d'un second réseau de lignes, réalisé au cours de la fabrication du composant microélectronique, sur le second niveau, le défaut résultant d'un désalignement des réseaux de lignes entre eux et d'une déformation des bords des lignes des réseaux, le procédé d'identification mettant en oeuvre une technique de diffusion des rayons X aux petits angles, le procédé étant **caractérisé en ce qu'**il comporte les étapes consistant à :

- acquérir, en éclairant le motif de contrôle, une pluralité de mesures d'intensité d'un faisceau de rayons X transmis ou réfléchi pour une pluralité d'angles d'incidence du faisceau de rayons X ;
- reconstruire, à partir de la pluralité de mesures d'intensité, au moins deux tiges de Bragg d'ordre n et -n et au moins une tige de Bragg d'un autre ordre d'une figure de diffraction ; et,
- appliquer une pluralité de tests sur la figure de diffraction pour déterminer le type du défaut affectant le motif de contrôle,

un repère orthonormé xyz étant associé au composant microélectronique, les lignes des premier et second réseaux de lignes étant orientées selon la direction y, et les premier et second réseaux de lignes étant superposés selon la direction z, selon des axes $q_x$ et $q_z$, associés respectivement aux directions x et z :

- un premier test de la pluralité de tests consiste à vérifier si une position selon l'axe $q_z$ d'au moins un maximum de la tige de Bragg d'ordre -n est identique à celle des maximums de la tige de Bragg d'ordre n ;
- un second test de la pluralité de tests consiste à vérifier si la tige de Bragg d'ordre n, ou la tige de Bragg d'ordre -n, est symétrique par rapport à l'axe $q_x$ ;
- un troisième test de la pluralité de tests consiste à vérifier si les tiges de Bragg d'ordre -n et n sont symétriques par rapport à une origine de la figure de diffraction de coordonnées $q_z = 0$ et $q_x = 0$ ; et,
- un quatrième test de la pluralité de tests consiste à vérifier si la position selon l'axe $q_z$ d'un extremum évolue en fonction de l'ordre de la tige de Bragg.

2. Procédé d'identification selon la revendication 1, dans lequel le type du défaut est identifié parmi les cas suivants, le désalignement étant **caractérisé par** un angle de désalignement $\alpha$ et la déformation étant **caractérisée par** un angle de déformation $\beta moy$ :

   - Cas 1, correspondant au cas idéal dans lequel les lignes sont parfaitement superposées et leurs bords ne sont pas déformés ;
   - Cas 2, correspondant au cas où les lignes sont superposées, mais leurs bords sont déformés de telle sorte qu'une moyenne de ces déformations soit nulle ;
   - Cas 3, correspondant au cas où les lignes sont décalées, mais leurs bords ne sont pas déformés ;
   - Cas 4, correspondant au cas où les lignes sont décalées et leurs bords déformés d'un même angle de déformation, ou bien les lignes sont décalées et leurs bords déformés d'un même angle de déformation moyen ;
   - Cas 5, correspondant au cas où les lignes sont décalées et leurs bords déformés mais selon des angles de déformation différents ; et,
   - Cas 6, correspondant à tous les autres défauts.

3. Procédé de contrôle (200) de la fabrication d'un composant microélectronique, le composant microélectronique comportant au moins un premier niveau et un second niveau, ainsi qu'un motif de contrôle résultant de la superposition d'un premier réseau de lignes réalisé au cours de la fabrication sur le premier niveau et d'un second réseau de lignes réalisé au cours de la fabrication sur le second niveau, le procédé comportant les étapes consistant à :

   - identifier (210) un type dont relève un défaut affectant le motif de contrôle en mettant en oeuvre un procédé d'identification (100) conforme à l'une quelconque des revendications précédentes ; et,
   - ajuster (220) des conditions de fabrication du composant microélectronique en fonction du type de défaut identifié.

4. Procédé de contrôle selon la revendication 3, dans lequel des conditions de fabrication optimales sont identifiées progressivement par une approche essai/erreur en itérant les étapes d'identification et d'ajustement pour une succession de composants microélectroniques.

5. Procédé de contrôle selon la revendication 3, dans lequel, suite à l'identification du type du défaut, le procédé de contrôle comporte une étape de mesure (215) d'une valeur d'au moins un paramètre caractéristique du défaut en tenant compte du type dudit défaut dans le choix d'une méthode instrumentale et/ou d'une méthode d'analyse, l'étape d'ajustement des conditions de fabrication prenant également en compte la valeur mesurée de chaque paramètre caractéristique.

6. Système instrumental (1) du type par diffusion des rayons X aux petits angles en incidence rasante - (GISAXS), comportant un détecteur, une électronique d'acquisition et un calculateur, **caractérisé en ce que** le calculateur est convenablement programmé pour que ledit système instrumental mette en oeuvre un procédé d'identification selon l'une quelconque des revendications 1 à 2 pour identifier un type dont relève un défaut affectant un motif de contrôle porté par un composant microélectronique analysé avec le système instrumental.

7. Produit programme d'ordinateur comportant des instructions logicielles qui, lorsqu'elles sont exécutées par un calculateur d'un système instrumental conforme à la revendication 9 permettent à ce dernier de mettre en oeuvre un procédé d'identification selon l'une quelconque des revendications 1 à 2.

**Patentansprüche**

1. Verfahren zum Identifizieren (100) einer Art, die zu einem Fehler gehört, der ein Kontrollmuster (Z) beeinflusst, das von einer mikroelektronischen Komponente (C) getragen wird, wobei die mikroelektronische Komponente mindestens eine erste Ebene und eine zweite Ebene aufweist, das Kontrollmuster aus der Überlagerung eines ersten Liniennetzes, das im Laufe der Herstellung der mikroelektronischen Komponente hergestellt wird, auf der ersten Ebene und eines zweiten Liniennetzes, das im Laufe der Herstellung der mikroelektronischen Komponente hergestellt wird, auf der zweiten Ebene resultiert, der Fehler aus einer Fehlausrichtung der Liniennetze zueinander und

EP 4 451 060 B1

einer Verformung der Ränder der Netzlinien resultiert, wobei das Identifizierungsverfahren eine Kleinwinkel-Röntgenstreuungstechnik einsetzt, wobei das Verfahren **dadurch gekennzeichnet ist, dass** es die Schritte umfasst, die aus Folgendem bestehen:

- Erfassen, durch Beleuchten des Kontrollmusters, einer Vielzahl von Intensitätsmessungen eines durchgelassenen oder reflektierten Röntgenstrahls für eine Vielzahl von Einfallswinkeln des Röntgenstrahls;
- Rekonstruieren, anhand der Vielzahl von Intensitätsmessungen, von mindestens zwei Bragg-Stäben der Ordnung n und -n und mindestens einem Bragg-Stab einer anderen Ordnung eines Beugungsmusters; und
- Anwenden einer Vielzahl von Tests auf das Beugungsmuster, um die Art des Fehlers zu bestimmen, der das Kontrollmuster betrifft,

wobei mit der mikroelektronischen Komponente ein orthonormales xyz-Koordinatensystem assoziiert ist, wobei die Linien des ersten und des zweiten Liniennetzes in der y-Richtung ausgerichtet sind, und wobei das erste und das zweite Liniennetz in der z-Richtung entlang der Achsen $q_x$ und $q_z$ überlagert sind, die jeweils mit der x- und der z-Richtung assoziiert sind:

- wobei ein erster Test der Vielzahl von Tests darin besteht, zu überprüfen, ob eine Position entlang der Achse $q_z$ von mindestens einem Maximum des Bragg-Stabs der Ordnung -n mit den Maxima des Bragg-Stabs der Ordnung n identisch ist;
- ein zweiter Test der Vielzahl von Tests darin besteht, zu überprüfen, ob der Bragg-Stab der Ordnung n oder der Bragg-Stab der Ordnung -n symmetrisch zu der Achse $q_x$ ist;
- ein dritter Test der Vielzahl von Tests darin besteht, zu überprüfen, ob die Bragg-Stäbe der Ordnung -n und n symmetrisch in Bezug auf einen Ursprung des Beugungsmusters mit den Koordinaten $q_z = 0$ und $q_x = 0$ sind; und
- ein vierter Test der Vielzahl von Tests darin besteht, zu überprüfen, ob sich die Position entlang der Achse $q_z$ eines Extremums abhängig von der Ordnung des Bragg-Stabs entwickelt.

2. Identifizierungsverfahren nach Anspruch 1, wobei die Art des Fehlers in den folgenden Fällen identifiziert wird wobei die Fehlausrichtung durch einen Fehlausrichtungswinkel $\alpha$ gekennzeichnet ist und die Verformung durch einen Verformungswinkel $\beta moy$ gekennzeichnet ist:

- Fall 1, der dem Idealfall entspricht, bei dem die Linien perfekt übereinander liegen und ihre Ränder nicht verformt sind;
- Fall 2, der dem Fall entspricht, dass die Linien übereinander liegen, ihre Ränder aber verformt sind, sodass ein Mittelwert dieser Verformungen null ist;
- Fall 3, der dem Fall entspricht, dass die Linien versetzt sind, ihre Ränder aber nicht verformt sind;
- Fall 4, der dem Fall entspricht, dass die Linien versetzt sind und ihre Ränder um denselben Verformungswinkel verformt sind, oder die Linien versetzt sind und ihre Ränder um denselben mittleren Verformungswinkel verformt sind;
- Fall 5, der dem Fall entspricht, dass die Linien versetzt sind und ihre Ränder verformt sind, aber unter verschiedenen Verformungswinkeln; und
- Fall 6, der allen anderen Fehlern entspricht.

3. Verfahren zur Kontrolle (200) der Herstellung einer mikroelektronischen Komponente, wobei die mikroelektronische Komponente mindestens eine erste Ebene und eine zweite Ebene aufweist, sowie ein Kontrollmuster, das sich aus der Überlagerung eines ersten Linienmusters, das während der Herstellung auf der ersten Ebene hergestellt wird, und eines zweiten Linienmusters, das während der Herstellung auf der zweiten Ebene hergestellt wird, resultiert, wobei das Verfahren Schritte umfasst, die aus Folgendem bestehen:

- Identifizieren (210) einer Art, zu der ein Fehler gehört, der das Kontrollmuster betrifft, indem ein Identifizierungsverfahren (100) nach einem der vorherigen Ansprüche durchgeführt wird; und,
- Anpassen (220) der Herstellungsbedingungen der mikroelektronischen Komponente abhängig von der Art des identifizierten Fehlers.

4. Kontrollverfahren nach Anspruch 3, wobei optimale Herstellungsbedingungen schrittweise durch einen Versuch-und-Fehler-Ansatz identifiziert werden, indem die Schritte eines Identifizierens und Anpassens für eine Abfolge von mikroelektronischen Komponenten iteriert werden.

5. Kontrollverfahren nach Anspruch 3, wobei das Kontrollverfahren nach Identifizieren der Art des Fehlers einen Schritt

9

eines Messens (215) eines Werts von mindestens einem für den Fehler charakteristischen Parameter umfasst, wobei die Art des genannten Fehlers bei der Auswahl einer instrumentellen Methode und/oder einer Analysemethode berücksichtigt wird, wobei der Schritt eines Anpassens der Herstellungsbedingungen auch den gemessenen Wert von jedem charakteristischen Parameter berücksichtigt.

**6.** Instrumentensystem (1) der Art einer Kleinwinkel-Röntgenstreuung bei streifendem Einfall - (GISAXS), das einen Detektor, eine Erfassungselektronik und einen Rechner aufweist, **dadurch gekennzeichnet, dass** der Rechner auf geeignete Weise programmiert ist, damit das genannte Instrumentensystem ein Identifizierungsverfahren nach einem der Ansprüche 1 bis 2 durchführt, um eine Art zu identifizieren, zu der ein Fehler gehört, der ein Kontrollmuster betrifft, das von einer mikroelektronischen Komponente getragen wird, die mit dem Instrumentensystem analysiert wird.

**7.** Computerprogramm, das Softwareanweisungen aufweist, die, wenn sie von einem Rechner eines Instrumentensystems nach Anspruch 9 ausgeführt werden, diesem ermöglichen, ein Identifizierungsverfahren nach einem der Ansprüche 1 bis 2 durchzuführen.

## Claims

**1.** A method for identifying (100) a type to which a defect affecting a test pattern (Z) carried by a microelectronic component (C) belongs, the microelectronic component including at least a first level and a second level, the test pattern resulting from the superposition of a first array of lines, realized during the manufacture of the microelectronic component on the first level, and a second array of lines, realized during the manufacture of the microelectronic component, on the second level, the defect resulting from a misalignment of the array of lines between each other and a deformation of the edges of the array of lines, the identification method implementing a small angle X-ray scattering technique, the method being **characterized in that** it includes the steps consisting of:

- acquiring, by illuminating the test pattern, a plurality of intensity measurements of a transmitted or reflected X-ray beam for a plurality of angles of incidence of the X-ray beam;
- reconstructing, from the plurality of intensity measurements, at least two Bragg rods of order n and -n and at least one Bragg rod of another order of a diffraction pattern; and,
- applying a plurality of tests on the diffraction pattern to determine the type of defect affecting the test pattern,

an orthonormal coordinate system xyz being associated with the microelectronic component, the lines of the first and second array of lines being oriented along the direction y, and the first and second array of lines being superposed along the direction z, along the axes $q_x$ and $q_z$, associated respectively with the directions x and z:

- a first test of the plurality of tests consists in verifying whether a position along the axis $q_z$ of at least one maximum of the Bragg rod of order -n is identical to that of the maximum of the Bragg rod of order n;
- a second test of the plurality of tests consists in verifying whether the Bragg rod of order n, or the Bragg rod of order -n, is symmetrical relative to the axis $q_x$;
- a third test of the plurality of tests consists in verifying whether the Bragg rods of order -n and n are symmetrical relative to an origin of the coordinates $q_z = 0$ and $q_x = 0$ of the diffraction pattern; and,
- a fourth test of the plurality of tests consists in verifying whether the position along the axis $q_z$ of an extremum evolves as a function of the order of the Bragg rod.

**2.** The identification method according to claim 1, wherein the type of defect is identified from among the following cases, the misalignment being **characterized by** a misalignment angle $\alpha$ and the deformation being **characterized by** a deformation angle $\beta_{moy}$:

- Case 1, corresponding to the ideal case wherein the lines are perfectly superposed, and their edges are not deformed;
- Case 2, corresponding to the case where the lines are superposed, but their edges are deformed so that an average of these deformations is zero;
- Case 3, corresponding to the case where the lines are offset, but their edges are not deformed;
- Case 4, corresponding to the case where the lines are offset and their edges deformed by the same deformation angle, or else the lines are offset and their edges deformed by the same average deformation angle;
- Case 5, corresponding to the case where the lines are offset and their edges deformed but at different deformation angles; and,
- Case 6, corresponding to all other defects.

3. The control method (200) for the manufacture of a microelectronic component, the microelectronic component including at least a first level and a second level, as well as a test pattern resulting from the superposition of a first array of lines realized during the manufacture on the first level and a second array of lines realized during the manufacture on the second level, the method including the steps consisting of:

- identifying (210) a type to which a defect, affecting the test pattern, belongs by implementing an identification method (100) in accordance with any one of the preceding claims; and,
- adjusting (220) the manufacturing conditions of the microelectronic component depending on the type of defect identified.

4. The control method according to claim 3, wherein optimal manufacturing conditions are identified progressively by a trial/error approach by iterating the identification and adjustment steps for a succession of microelectronic components.

5. The control method according to claim 3, wherein, following the identification of the type of defect, the control method comprises a step of measuring (215) a value of at least one characteristic parameter of the defect taking into account the type of said defect in the choice of an instrumental method and/or an analysis method, the step of adjusting the manufacturing conditions also taking into account the measured value of each characteristic parameter.

6. An instrumental system (1) of the type by small angle X-ray scattering in grazing incidence - (GISAXS), comprising a detector, acquisition electronics and a computer, **characterized in that** the computer is suitably programmed for the said instrumental system to implement an identification method according to any one of claims 1 to 2 to identify a type to which a defect affecting a test pattern carried by a microelectronic component analyzed with the instrumental system belongs.

7. A computer program product including software instructions which, when executed by a computer of an instrumental system in accordance with claim 9 allow the latter to implement an identification method according to any one of claims 1 to 2.

FIG.1

## FIG.2

## FIG.3

Mesure de 2 ordres n et -n — 105

Q1: La position en qz des tiges de Bragg d'ordre n et –n sont identiques? — 110

oui

non

Q2 : La tige de Bragg d'ordre n est symétrique par rapport à qz=0? — 120

Q3 : Les tiges de Bragg d'ordre n et –n sont symétriques par rapport au centre qz=0 / qx=0 ? — 130

125

oui

non

oui

non

Mesure d'un 3ème ordre k

Q5 : La tige de Bragg d'ordre n est symétrique par rapport à un axe selon qz ≠ 0? — 150

Q4 : La position en qz d'un min (ou d'un max secondaire) évolue en fonction de l'ordre n?

non

oui — 140

oui

non

CAS 1
Lignes parfaites

CAS 2
Lignes superposées mais déformées

CAS 3
Lignes décalées et déformées

CAS 4
Lignes imparfaites
Type 1

CAS 5
Lignes imparfaites
Type 2

CAS 6
Autres

$\alpha = \beta1 = \beta2 = \beta moy = 0$

$\alpha = 0$
$\beta1 = -\beta2 \neq 0$
$\beta moy = 0$

$\alpha \neq 0$
$\beta1 = \beta2 = 0$
$\beta moy = 0$

$\alpha = \beta1 = \beta2 = \beta moy \neq 0$

$\alpha = \beta moy \neq 0$
$\beta1 \neq \beta2$

$\alpha \neq 0$
$\alpha \neq \beta1 = \beta2 = \beta moy$

*Toutes autres combinaisons*

FIG.4

EP 4 451 060 B1

FIG.5

EP 4 451 060 B1

200

210

215

220

FIG.6

## RÉFÉRENCES CITÉES DANS LA DESCRIPTION

**Documents brevets cités dans la description**

- US 20160320319 A1
- US 20150117610 A1
- EP 4137889 A1
- FR 2202371
- FR 2301672